# EUROPÄISCHE PATENTSCHRIFT

(11) **EP 0 865 233 B1**
(45) Veröffentlichungstag und Bekanntmachung des Hinweises auf die Patenterteilung: **04.08.2004**
(21) Anmeldenummer: 98104373.0
(22) Anmeldetag: 11.03.1998
(51) Int. Cl.: H05K 5/02

(54) **Steckkarte für elektronische Geräte**
Insert card for electronic apparatus
Carte enfichable pour des appareils électroniques

(30) Priorität: 13.03.1997 DE 19710515
(43) Veröffentlichungstag der Anmeldung: 16.09.1998
(73) Patentinhaber: ITT MANUFACTURING ENTERPRISES, INC., Wilmington, Delaware 19801 (US)
(72) Erfinder: Schremmer, Andreas, 73614 Schorndorf (DE)
(74) Vertreter: Dreiss, Fuhlendorf, Steimle & Becker

(56) Entgegenhaltungen:
- DE-A- 4 406 644
- US-A- 5 701 230

## Beschreibung

Die vorliegende Erfindung bezieht sich auf eine Steckkarte für elektronische Geräte nach dem Oberbegriff des Anspruchs 1.

Aus der DE 44 06 644 A1 und der US 5 513 074 A sind halbschalenartig ausgebildete metallische Gehäuseelemente bekannt, die an ihrer einen Stirn umgebogene Lappen besitzen, die in von der Oberfläche her zugängliche Schlitze eines Steckverbinders eingesteckt werden, worauf die beiden Gehäuseelemente aufeinanderzu verschwenkt und mit einander verrastet bzw. laserverschweißt werden. Eine derartige vormontierte Lappen/Nut-Verbindung zwischen Gehäuseelement und Steckverbinder ist bis zum Verrasten bzw. Laserverschweißen der beiden Gehäuseelemente miteinander relativ lose, was die Handhabung bei der weiteren Montage erschwert.

Aufgabe der vorliegenden Erfindung ist es deshalb, eine Steckkarte für elektronische Geräte der eingangs genannten Art zu schaffen, bei der die Vormontage eines Gehäuseelementes mit einem anderen Element der Steckkarte eine Montageerleichterung für die folgenden Montageschritte der Steckkarte zur Folge hat.

Zur Lösung dieser Aufgabe sind bei einer Steckkarte für elektronische Geräte der eingangs genannten Art die im Anspruch 1 angegebenen Merkmale vorgesehen.

Durch die erfindungsgemäßen Maßnahmen ist erreicht, dass das eine Teil des Gehäuseelementes am anderen Teil unter Vorspannung eingebracht und gehalten wird, so dass es in einer bestimmten Position während der weiteren Montage verharrt. Mit anderen Worten, das so vormontierte Teil des betreffenden Gehäuseelementes ist nicht lose gehalten und kann somit nicht unbeabsichtigt wegfallen. Dadurch ist gleichzeitig eine exakte Ausrichtung des einen Teils am anderen Teil des Gehäuseelementes gegeben.

Vorteilhafte Ausgestaltungen ergeben sich aus den Merkmalen des Anspruchs 2 und/oder 3, bzw. 2 und/oder 4.

Eine jeweils bevorzugte Ausführungsform, die eine einfache Vormontage bietet, ergibt sich aus den Merkmalen des Anspruchs 5 und/oder 7, bzw. 6 und/oder 7.

Zweckmäßigerweise sind dabei entweder die Merkmalen gemäß Anspruchs 8 und/oder 9 oder die des Anspruchs 10 und/oder 11 vorgesehen, die ein einfaches Vorspannen des einen Teils des Gehäuseelements und eine schnelle und einfache Vormontage erlauben.

Weitere Ausgestaltungen ergeben sich aus den Merkmalen eines oder mehrerer der Ansprüche 12 bis 14.

Weitere Einzelheiten der Erfindung sind der folgenden Beschreibung zu entnehmen, in der Erfindung anhand des in der Zeichnung dargestellten Ausführungsbeispieles näher beschrieben und erläutert ist. Es zeigen:
- Figur 1: in perspektivischer schematischer Darstellung eine Steckkarte für elektronische Geräte in zusammengebautem Zustand gemäß einem bevorzugten Ausführungsbeispiel Ausführungsbeispiel vorliegender Erfindung,
- Figuren 2A und 2B: in perspektivischer schematischer Darstellung jeweils eines der beiden Teile des oberen Gehäuseelementes der Steckkarte nach Figur 1 und
- Figur 3: verkleinerte schematische Seitenansichten und Draufsichten der Steckkarte zur Darstellung der Vormontageschritte der beiden Teile des oberen Gehäuseelementes.

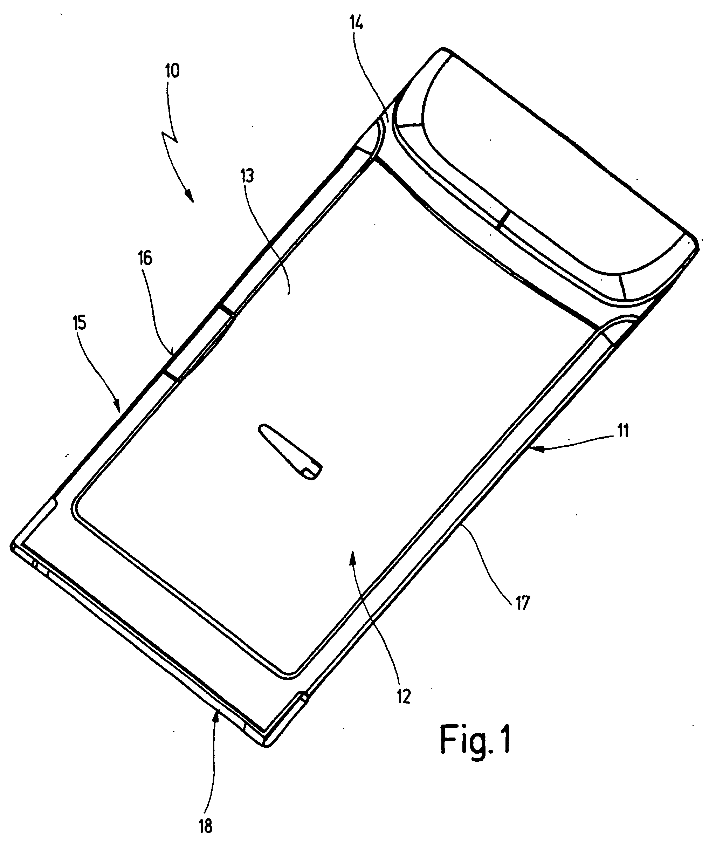

Die Figur 1 in zusammengebautem Zustand dargestellte Steckkarte 10 für elektronische Geräte gemäß einem bevorzugten Ausführungsbeispiel vorliegender Erfindung besitzt ein Gehäuse 15 aus einem unteren, einteiligen Gehäuseelement 11 und einem oberen aus zwei Teilen 13 und 14 bestehenden Gehäuseelement 12. Das untere Gehäuseelement 11 und der vordere Teil 13 des oberen Gehäuseelementes 12 der eine länglich rechteckige flache Form aufweisenden Steckkarte 10 bestehen aus dünnem geformtem Metallblech, die mit ihren Längsseitenrändern 16 verrastend übereinander bzw. ineinander greifen. An der vorderen Querseite 17 ist ein nur schematisch gezeigter Steckverbinder 18 ortsfest gehalten. Zwischen den beiden Gehäuseelementen 11 und 12 ist eine nicht dargestellte Leiterplatte, die sich über im Wesentlichen die gesamte Grundfläche des unteren Gehäuseelementes 11 erstreckt, angeordnet.

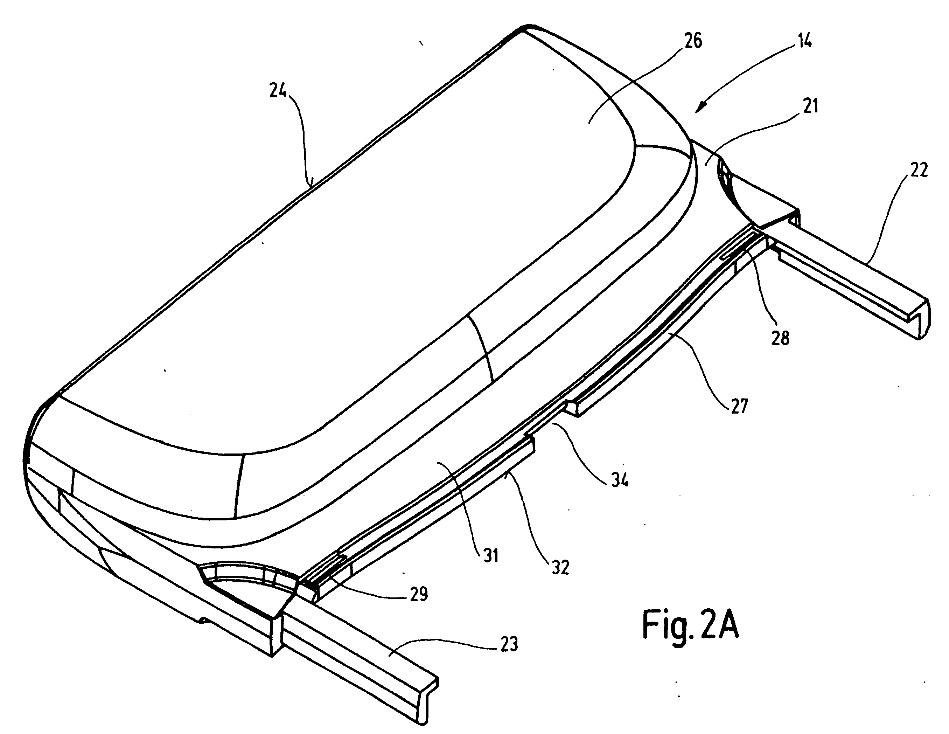

Figur 2A zeigt das aus Kunststoff bestehende hintere Gehäuseteil 14 des oberen Gehäuseelementes 12. Dieser hintere Kunststoff-Teil 14 des oberen Gehäuseelements 12 besitzt einen im Wesentlichen rechteckförmigen Bereich 21, der mit zwei seitlichen, längsgerichteten, im Schnitt L-förmigen Stegen 22 und 23 versehen ist, zwischen denen in nicht dargestellter Weise die Leiterplatte führend aufgenommen ist, die sich bis im Wesentlichen zur rückwärtigen Stirn 24 des Kunststoff-Teils 14 erstreckt. Der rechteckförmige Bereich 21 besitzt zur rückwärtigen Stirn 24 hin einen erhabenen Bereich 26 zur Aufnahme von auf der Leiterplatte vorgesehenen größeren elektronischen Bauteilen und zwischen den beiden Stegen 22 und 23 einen freien Rand 27, der im Wesentlichen konvex gewölbt ist. Nahe den beiden Stegen 22 und 23 besitzt der freie Rand 27 jeweils einen Schlitz 28 und 29, der sich im Wesentlichen parallel zur Rückstirn 24 bzw. zur Quererstreckung des Kunststoff-Teils 14 erstreckt. Beide Schlitze 28 und 29 sind sowohl von der Oberseite 31 als auch von der Unterseite 32 des Gehäuseelementteils 14 her offen. Zwischen den beiden schmalen Schlitzen 28 und 29 ist im Quermittenbereich eine Nut 34 vorgesehen, die sich über die gesamte Dicke des rechteckförmigen Bereichs 21 erstreckt und die vom freien Rand 27 her offen ist. Die Tiefe der Nut 34 ist etwa gleich oder nur wenig größer als die Breite der Schlitze 28, 29. Die Längenabmessungen von Nut 34 und Schlitzen 28 und 29 sind etwa gleich. Während sich die beiden Schlitze 28 und 29 in einer Flucht parallel zur Quererstreckung des Kunststoff-Teils 14 bzw. von dessen Rückstirn 24 erstrecken, befindet sich demgegenüber die Nut 34 aufgrund der konvexen Wölbung des freien Randes 27 in eine nach vorne hin versetzte Position.

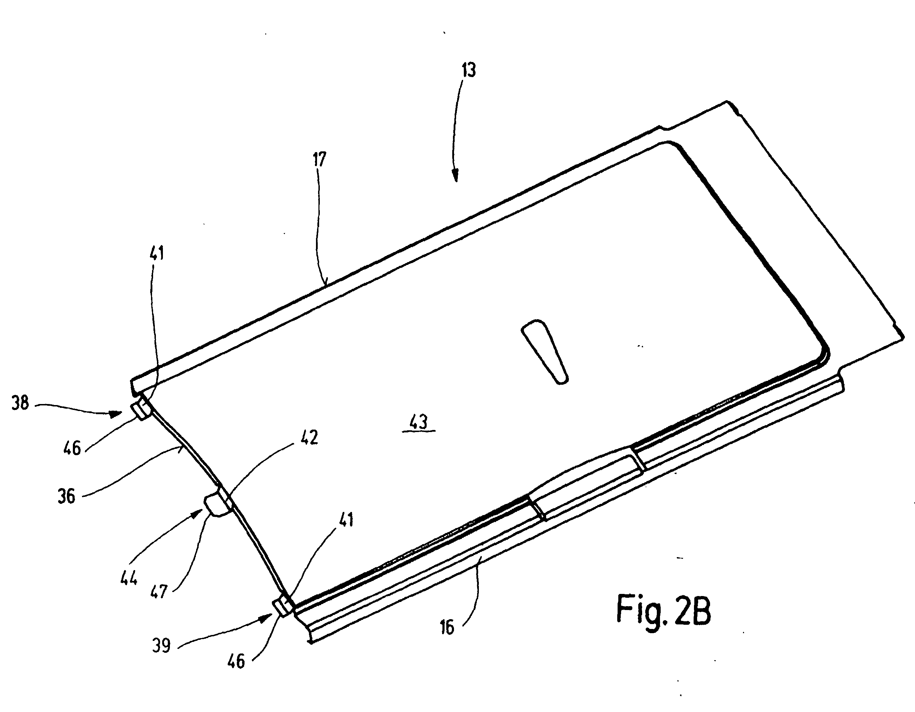

Figur 2B zeigt den vorderen Teil 13 des oberen Gehäuseelementes 12 aus dünnem Metallblech. Die dem hinteren Gehäuseelementteil 14 zugewandte Stirn 36 des Metall-Teils 13 ist konkav gewölbt und besitzt zwei identische seitlich angeformte Lappen 38 und 39 und einen quermittig angeformten Lappen 44. Alle drei Lappen 38, 39 und 44 sind einstückig mit dem metallischen Gehäuseelementteil 13 und mit einer Kröpfung 41 bzw. 42 versehen. Die Lappen 38, 39 und 44 sind aus der Ebene 43 des Gehäuseelementteils 13 um 90° nach innen und danach wiederum um 90° parallel zur Ebene 43 umgebogen. Die dadurch entstehende Kröpfung 41 bzw. 42 entspricht in ihrer Breite etwa der Dicke des rechteckförmigen Bereichs 21 des Gehäuseelementteils 14 im Bereich des freien Randes 27. Die freien Enden 46 der Lappen 38 und 39 liegen in einer zum abgewandten Rand 17 des Gehäuseelementteils 13 parallelen Flucht, während das freie Ende 47 des Lappens 44 demgegenüber zurückgesetzt ist. Wie der Figur 2B zu entnehmen ist, sind die Kröpfungen 41 und 42 in ihrer Breite etwa gleich, während der umgebogene freie Endabschnitt des mittleren Lappens 44 etwas länger ist als der der äußeren Lappen 38 und 39.

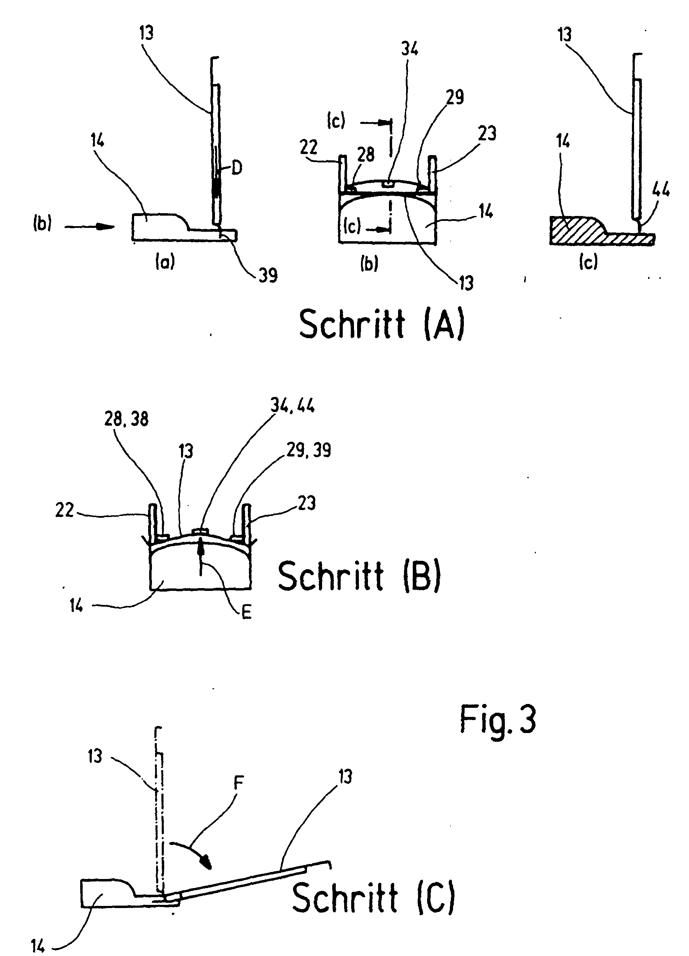

Anhand der Figur 3 sei nun die Montage des vorderen (Metall-) Gehäuseelementteils 13 am hinteren (Kunststoff-) Gehäuseelementteil 14 beschrieben, wobei diese Steckkarten-Vormontage erfolgen kann, bevor oder nachdem der Kunststoff-Teil 14 mit der nicht dargestellten Leiterplatte verbunden ist.

Zunächst wird das vordere Metall-Teil 13 des oberen Gehäuseelements 12 senkrecht zum horizontal ausgerichteten hinteren Kunststoff-Teil 14 des oberen Gehäuseelements 12 derart gehalten, dass die beiden äußeren Lappen 38 und 39 über den beiden äußeren Schlitzen 28 und 29 angeordnet sind. Danach wird das vordere Metall-Teil 13 in Richtung des Pfeiles D bewegt, so dass die äußeren Lappen 38 und 39 des Metall-Teils 13 in die äußeren Schlitze 28 und 29 des Kunststoff-Teils 14 eindringen (Schritt A). In diesem eingesteckten Zustand liegen die Kröpfung 41 der äußeren Lappen 38, 39 auf der Oberfläche des rechteckförmigen Bereichs 21 des Kunststoff-Teils 14 auf, während das vordere Ende 47 des mittleren Lappens 44 aufgrund der konkaven Wölbung der Stirn 36 in einem geringen Abstand oberhalb dieser Oberfläche endet. Außerdem ist der mittlere Lappen 44 des Metall-Teils 13 gegenüber dem Grund der Nut 34 des hinteren Kunststoff-Teils 14 zurückgesetzt.

Gemäß Schritt B wird in diesem Zustand das Metall-Teil 13 in Richtung des Pfeiles E mittig, d.h. im Bereich des mittleren Lappens 44 derart gebogen, dass bei in den äußeren Schlitzen 28 und 29 verbleibenden äußeren Lappen 38 und 39 der mittlere Lappen 44 in eine Flucht über die mittlere Nut 34 des Kunststoff-Teils 14 gelangt.

In diesem Zustand wird das Metall-Teil 13 in Richtung des Pfeiles F in die Ebene des Kunststoff-Teils 14 verschwenkt, wobei der freie Endbereich des mittleren Lappens 44 des Metall-Teils 13 unter die Unterseite des Bereichs 21 des Kunststoff-Teils 14 hinter den Grund der Nut 34 greift. In gemäß Pfeil F nach unten verschwenktem Zustand greifen auch die freien Enden der äußeren Lappen 38 und 39 über die Unterseite des Bereichs 21 des Kunststoff-Teils 14 und es liegt die Kröpfung 41, 42 aller Lappen 38, 39 und 44 im betreffenden Schlitz 28, 29 bzw. parallel zum Grund der Nut 34. In diesem unter Verformung des Metall-Teils 13 in das Kunststoff-Teil 14 steckend eingebrachtem und verschwenktem Zustand ist das Metall-Teil 13 in einer nach Schritt C angedeuteten Schräge elastisch gehalten. In diesem Zustand der Vormontage der beiden Teile 13 und 14 des oberen Gehäuseelementes 12 können weitere Montageschritte an der Steckkarte 10 vorgenommen werden, ohne dass die Gefahr besteht, dass das Metall-Teil 13 sich vom Kunststoff-Teil 14 löst. Erst nach weiteren, dem Schritt C folgenden Montageschritten wird das Metall-Teil 13 weiter gemäß Pfeil F nach unten verschwenkt und dabei mit dem unteren metallischen Gehäuseelement 11 verrastend verbunden, wobei gleichzeitig zwichen den beiden metallischen Gehäuseelementen bzw. -teilen der Steckverbinder 18 gehalten ist.

Es versteht sich, dass nach dem Verschwenken des Metall-Teils 13 in Richtung des Pfeiles F das Metall-Teil 13 aus seiner gebogenen Form elastisch wieder in die ebene Form seiner Oberfläche zurückkehrt.

Gemäß einer nicht dargestellten Ausführungsform vorliegender Erfindung ist es möglich, Schlitz 28 bzw. 29 und Nut 34 gegeneinander in der Weise zu vertauschen, dass am Kunststoff-Gehäuseelementteil 14 außenseitig zwei Nuten und innenseitig ein Schlitz und am Gehäuselementteil 13 entsprechend geformte und in der Länge angepasste Lappen vorgesehen sind. Dabei ist das Kunststoffteil 14 stirnseitig konkav während das Metallteil 13 stirnseitig konvex (mit zueinander passenden Wölbungen) geformt ist. Die Montage erfolgt grundsätzlich in der zur zeichnerisch dargestellten Ausführungsform entsprechenden Weise:

Mittiges Einstecken des Lappens in die Nut und beidaußenseitiges Biegen des Metalllteils derart, dass die äußeren Lappen in Flucht über die äußeren Nuten des Kunststoffteils gelangen, worauf das Verschwenken in Richtung des Pfeiles F erfolgen kann.

Es versteht sich, dass es auch möglich ist, Schlitze 28, 29 und Nuten 34 mehrmals, bspw. abwechselnd anzuordnen.

## Patentansprüche

1. Steckkarte (10) für elektronische Geräte, in etwa länglich rechteckigförmiger, flacher Form, mit einem ein oberes und ein unteres im Wesentlichen halbschalenartig ausgebildetes Gehäuseelement (11, 12) aufweisenden Gehäuse (15), mit einer im Gehäuse (15) aufgenommenen Leiterplatte und mit einem an einem Querende (17) der Leiterplatte gehaltenen Steckverbinder (18), **dadurch gekennzeichnet, dass** das eine Gehäuseelement (11, 12) durch zwei Teile (13, 14) gebildet ist, von denen das eine Teil (14) längs eines gewölbten Randes (27) abwechselnd mindestens einen zur Ober- und Unterseite hin offenen Schlitz (28, 29) und mindestens eine vom Rand (27) her offene durchgehende Nut (34) und das andere Teil (13) von seiner ebenen Stirn (36) entsprechend geformte und in der Länge angepasste abstehende gekröpfte Lappen (38, 39, 44) aufweist.

2. Steckkarte nach Anspruch 1, **dadurch gekennzeichnet, dass** die Stirn (36) des anderen Teils (13) eine dem gewölbten Rand (27) des einen Teils (14) entsprechende gewölbte Form besitzt.

3. Steckkarte nach Anspruch 2, **dadurch gekennzeichnet, dass** der Rand (27) des einen Teils (14) konvex und die Stirn (36) des anderen Teils (13) konkav gewölbt ist.

4. Steckkarte nach Anspruch 2, **dadurch gekennzeichnet, dass** der Rand (27) des einen Teils (14) konkav und die Stirn (36) des anderen Teils (13) konvex gewölbt ist.

5. Steckkarte nach mindestens einem der Ansprüche 1 bis 3, **dadurch gekennzeichnet, dass** der Rand (27) des einen Teils (14) mit einer mittigen Nut (34) und zwei äußeren Schlitzen (28, 29) versehen ist.

6. Steckkarte nach mindestens einem der Ansprüche 2 und 4, **dadurch gekennzeichnet, dass** der Rand (27) des einen Teils (14) mit einem mittigen Schlitz und zwei äußeren Nuten versehen ist.

7. Steckkarte nach mindestens einem der vorhergehenden Ansprüche, **dadurch gekennzeichnet, dass** das Maß der Kröpfung (41, 42) der Lappen (38, 39, 44) des anderen Teils (13) der Dicke des einen Teils (14) entspricht.

8. Steckkarte nach Anspruch 5, **dadurch gekennzeichnet, dass** die Wölbung der Stirn (36) des anderen Teils (13) derart ist, dass von den im Wesentlichen gleich langen Lappen (38, 39, 44) der mittlere Lappen (44) gegenüber den beiden äußeren Lappen (38, 39) derart zurücksteht, dass bei in die Schlitze (28, 29) eingesteckten äußeren Lappen (38, 39) der mittlere Lappen (44) gegenüber der Oberfläche des einen Teils (14) frei bewegbar ist.

9. Steckkarte nach den Ansprüche 5 und 8, **dadurch gekennzeichnet, dass** bei in die Schlitze (28, 29) des einen Teils (14) eingesteckten äußeren Lappen (38, 39) des anderen Teils (13) der mittlere Lappen (44) durch Druck auf die Quermitte der Oberfläche des anderen Teils (13) und Kippen des anderen Teils (13) zur Leiterplatte hin in die mittlere Nut (34) und unter die Innenfläche des einen Teils (14) einfädelbar ist.

10. Steckkarte nach Anspruch 6, **dadurch gekennzeichnet, dass** die Wölbung der Stirn (36) des anderen Teils (13) derart ist, dass von den im Wesentlichen gleich langen Lappen (38, 39, 44) die äußeren Lappen gegenüber dem mittleren Lappen derart zurückstehen, dass bei in den Schlitz eingestecktem mittleren Lappen die äußeren Lappen (44) gegenüber der Oberfläche des einen Teils (14) frei bewegbar sind.

11. Steckkarte nach den Ansprüchen 6 und 8, **dadurch gekennzeichnet, dass** bei in den Schlitz des einen Teils (14) eingestecktem mittleren Lappen des anderen Teils (13) die äußeren Lappen durch Druck auf die Außenseiten der Oberfläche des anderen Teils (13) und Kippen des anderen Teils (13) zur Leiterplatte hin in die äußeren Nuten (34) und unter die Innenfläche des einen Teils (14) einfädelbar sind.

12. Steckkarte nach mindestens einem der vorhergehenden Ansprüche, **dadurch gekennzeichnet, dass** das obere Gehäuseelement (12) zweiteilig ist.

13. Steckkarte nach mindestens einem der vorhergehenden Ansprüche, **dadurch gekennzeichnet, dass** das eine Teil (14) des Gehäuseelements (12) aus Kunststoff und das andere Teil (13) des Gehäuseelements (12) aus dünnem Metallblech ist.

14. Steckkarte nach den Ansprüche 1 und 13, **dadurch gekennzeichnet, dass** der metallische Teil (13) des oberen Gehäuseelements (12) und das untere ebenfalls metallische Gehäuseelement (11) längsrandseitig miteinander verrastbar sind.

## Claims

1. Plug-in card (10) for electronic devices, with a substantially elongate rectangular flat shape, comprising a housing (15) having an upper and a lower, substantially shell-like housing element (11, 12), comprising a printed circuit board received in the housing (15) and comprising a plug-in connector (18) held at a transverse end (17) of the printed circuit board, **characterised in that** the one housing element (11, 12) is formed by two parts (13, 14), of which one part (14), along a curved edge (27), has, alternately, at least one slot (28, 29) open toward the upper and lower sides and at least one continuous groove (34) open from the edge (27), and the other part (13) has tabs (38, 39, 44) bent at right angles and projecting from the flat front (36) of the part (13) and which are correspondingly shaped and adapted in length thereto.

2. Plug-in card according to claim 1, **characterised in that** the front (36) of the other part (13) has a curved shape corresponding to the curved edge (27) of one part (14).

3. Plug-in card according to claim 2, **characterised in that** the edge (27) of one part (14) is convex and the front (36) of the other part (13) is concave.

4. Plug-in card according to claim 2, **characterised in that** the edge (27) of one part (14) is concave and the front (36) of the other part (13) is convex.

5. Plug-in card according to at least any one of claims 1 to 3, **characterised in that** the edge (27) of one part (14) is provided with a central groove (34) and two outer slots (28, 29).

6. Plug-in card according to at least any one of claims 2 to 4, **characterised in that** the edge (27) of one part (14) is provided with a central slot and two outer grooves.

7. Plug-in card according to at least any one of the preceding claims, **characterised in that** the extent of the right-angle bend (41, 42) of the tabs (38, 39, 44) of the other part (13) corresponds to the thickness of one part (14).

8. Plug-in card according to claim 5, **characterised in that** the curve of the front (36) of the other part (13) is such that, of the tabs (38, 39, 44) of substantially equal length, the central tab (44) is set back with respect to the two other tabs (38, 39) in such a way that when the outer tabs (38, 39) are inserted in the slots (28, 29), the central tab (44) is freely movable with respect to the surface of one part (14).

9. Plug-in card according to claims 5 and 8, **characterised in that** when the outer tabs (38, 39) of the other part (13) are inserted in the slot (28, 29) of one part (14), the central tab (44) can be threaded into the central groove (34) and under the inner face of one part (14) as a result of pressure on the transverse centre of the surface of the other part (13) and tilting of the other part (13) toward the printed circuit board.

10. Plug-in card according to claim 6, **characterised in that** the curve of the front (36) of the other part (13) is such that, of the tabs (38, 39, 44) of substantially equal length, the outer tabs are set back with respect to the central tab in such a way that when the central tab is inserted in the slot, the outer tabs (44) are freely movable with respect to the surface of one part (14).

11. Plug-in card according to claims 6 and 8, **characterised in that** when the central tab of the other part (13) is inserted in the slot of one part (14), the outer tabs can be threaded into the outer grooves (34) and under the inner face of one part (14) as a result of pressure on the outer sides of the surface of the other part (13) and tilting of the other part (13) toward the printed circuit board.

12. Plug-in card according to at least any one of the preceding claims, **characterised in that** the upper housing element (12) is of two-part construction.

13. Plug-in card according to at least any one of the preceding claims, **characterised in that** one part (14) of the housing element (12) is made of plastics material and the other part (13) of the housing element (12) of thin sheet metal.

14. Plug-in card according to claims 1 and 13, **characterised in that** the metal part (13) of the upper housing element (12) and the lower, likewise metal, housing element (11) can be latched to one another at their longitudinal edges.

## Revendications

1. Carte enfichable (10) pour appareils électroniques, de forme approximativement plate, allongée et rectangulaire, comportant un boîtier (15) présentant un élément de boîtier supérieur (11) et un élément de boîtier inférieur (12), réalisés chacun sensiblement en forme de demi-coque, comportant une carte à circuits imprimés reçue dans le boîtier (15) et comportant un connecteur enfichable (18) maintenu sur une extrémité transversale (17) de la carte à circuits imprimés, **caractérisée en ce que** l'un des éléments de boîtier (11, 12) est formé par deux parties (13, 14) dont une partie (14) présente le long d'un bord (27) bombé alternativement au moins une fente (28, 29) ouverte respectivement vers la face supérieure et vers la face inférieure et au moins une gorge (34) continue ouverte depuis le bord (27), et l'autre partie (13) présente depuis sa face frontale plane (36) des pattes (38, 39, 44) coudées et en saillie formées de manière correspondante et de longueur adaptée.

2. Carte enfichable selon la revendication 1, **caractérisée en ce que** la face frontale (36) de l'autre partie (13) possède une forme bombée correspondant au bord (27) bombé de ladite une partie (14).

3. Carte enfichable selon la revendication 2, **caractérisée en ce que** le bord (27) de ladite une partie (14) est bombé sous forme convexe et la face frontale (36) de l'autre partie (13) est bombée sous forme concave.

4. Carte enfichable selon la revendication 2, **caractérisée en ce que** le bord (27) de ladite une partie (14) est bombé de forme concave et la face frontale (36) de l'autre partie (13) est bombée de forme convexe.

5. Carte enfichable selon au moins l'une des revendications 1 à 3, **caractérisée en ce que** le bord (27) de ladite une partie (14) est pourvue d'une gorge centrale (34) et de deux fentes (28, 29) extérieures.

6. Carte enfichable selon au moins l'une des revendications 2 à 4, **caractérisée en ce que** le bord (27) de ladite une partie (14) est pourvu d'une fente centrale et de deux gorges extérieures.

7. Carte enfichable selon au moins l'une des revendications précédentes, **caractérisée en ce que** la dimension du coudage (41, 42) des pattes (38, 39, 44) de l'autre partie (13) correspond à l'épaisseur de ladite une partie (14).

8. Carte enfichable selon la revendication 5, **caractérisée en ce que** le bombement de la face frontale (36) de l'autre partie (13) est tel que parmi les pattes (38, 39, 44) qui ont sensiblement la même longueur, la patte médiane (44) est en retrait par rapport aux deux pattes extérieures (38, 39) de telle sorte que lorsque les pattes extérieures (38, 39) sont enfichées dans les fentes (28, 29), la patte médiane (44) est librement mobile par rapport à la surface de ladite une partie (14).

9. Carte enfichable selon les revendications 5 et 8, **caractérisée en ce que** lorsque les pattes extérieures (38, 39) de l'autre partie (13) sont enfichées dans les fentes (28, 29) de ladite une partie (14), la patte médiane (44) peut être enfilée jusque dans la gorge médiane (34) et au-dessous de la surface intérieure de ladite une partie (14) par pression sur le milieu transversal de la surface de l'autre partie (13) et par basculement de l'autre partie (13) vers la carte à circuits imprimés.

10. Carte enfichable selon la revendication 6, **caractérisée en ce que** le bombement de la face frontale (36) de l'autre partie (13) est tel que parmi les pattes (38, 39, 44) qui ont sensiblement la même longueur, les pattes extérieures sont en retrait par rapport à la patte médiane de telle sorte que lorsque la patte médiane est enfichée dans la fente, les pattes extérieures (44) sont librement mobiles par rapport à la surface de ladite une partie (14).

11. Carte enfichable selon les revendications 6 et 8, **caractérisée en ce que** lorsque la patte médiane de l'autre partie (13) est enfichée dans la fente de ladite une partie (14), les pattes extérieures peuvent être enfilées jusque dans les gorge extérieures (34) et au-dessous de la surface intérieure de ladite une partie (14) par pression sur les faces extérieures de la surface de l'autre partie (13) et par basculement de l'autre partie (13) vers la carte à circuits imprimés.

12. Carte enfichable selon l'une des revendications précédentes, **caractérisée en ce que** l'élément de boîtier supérieur (12) est en deux parties.

13. Carte enfichable selon l'une des revendications précédentes, **caractérisée en ce que** ladite une partie (14) de l'élément de boîtier (12) est en matière plastique et l'autre partie (13) de l'élément de boîtier (12) est une mince tôle métallique.

14. Carte enfichable selon les revendications 1 et 13, **caractérisée en ce que** la partie métallique (13) de l'élément de boîtier supérieur (12) et l'élément de boîtier inférieur (11) également métallique peuvent être enclenchés l'une à l'autre sur le côté du bord longitudinal.
